# EUROPEAN PATENT APPLICATION

(11) **EP 0 977 243 A2**
(43) Date of publication of application: **02.02.2000**
(21) Application number: 99305854.4
(22) Date of filing: 23.07.1999
(51) Int. Cl.: H01L 21/00

(54) **Plasma etching apparatus using halogen type gas plasma**

(30) Priority: 27.07.1998 JP 21071798
(71) Applicant: Speedfam Co., Ltd., Kanagawa 252-1123 (JP)
(72) Inventor: Sadohara, Takeshi, Ayase-shi, Kanagawa 252-1123 (JP); Yanagisawa, Michihiko, Ayase-shi, Kanagawa 252-1123 (JP); Iida, Shinya, Ayase-shi, Kanagawa 252-1123 (JP); Horiike, Yasuhiro, Hoya-shi, Tokyo 202-0021 (JP)
(74) Representative: SERJEANTS

(57) **Abstract**

In a related art plasma etching apparatus, excessive neutral active species which have not contributed to the etching are diffused within a vacuum container, causing corrosion on an inner wall of the vacuum container, and edge sections of a semiconductor wafer affixed on a holder to be deeply etched.

A plasma etching apparatus of the present invention is provided with a reactive member 6 at a substrate holder 30, and by this reactive member 6, neutral active species of fluorine which would not contribute to the etching are absorbed before the neutral active species of fluorine reach an inner wall of a vacuum container 1. Since reactive members 6 are also disposed on the inner wall of the vacuum container 1 and on covers 34, 37, the neutral active species of fluorine are absorbed also by these reactive members 6. Therefore, the corrosion on the inner wall of the vacuum container 1 or the like would not occur as it would be in the conventional way. In addition, neutral active species of fluorine which attempt to go around to a back side of a semiconductor wafer 50 are absorbed by the reactive member 6 disposed at the substrate holder 30, so that edge sections of the semiconductor wafer 50 would not be deeply etched as they would in the conventional way.

## Description

### Background of the Invention

### 1. Field of the Invention:

The present invention relates to a plasma etching apparatus for performing plasma etching within a vacuum container using a halogen type gas consisting mainly of a halogen compound.

### 2. Description of the Related Art:

Lately, etching methods using plasma have been experimentally practiced as a method of polishing silicon (Si) semiconductor wafers, and among them, an etching method using a downflow region of plasma has been used for locally etching surfaces of wafers. In this etching method, a halogen type gas is introduced into a vacuum container of a plasma etching apparatus via a reaction tube, and the halogen type gas plasma is blasted locally on to a surface of a semiconductor wafer which is vacuum-held on a holder. The semiconductor wafer is further mounted on an X-Y stage within the vacuum container. By moving this stage, the position of the gas plasma blasting locally onto the wafer surface is changed, thereby selecting a region to be etched.

However, the process performed by the above related art plasma etching apparatus would be an etching process performed mainly by neutral active species of atoms and molecules, and not by ions of the halogen element. Hence it is suitable as an etching method as it does not cause substantial damage to the surface of the semiconductor wafer, however excessive neutral active species that did not contribute to the etching can diffuse within the vacuum container. Therefore, corrosion on the inner wall surface of the vacuum container may result from these neutral active species, and these neutral active species may go around to the back surface of the semiconductor wafer which is fixed by vacuum-holding on the holder to etch the edge sections of the semiconductor wafer.

### SUMMARY OF THE INVENTION

The present invention was made to address these problems, and is characterized in that, in a plasma etching apparatus for performing plasma etching within a vacuum container using a halogen type gas, a member which reacts with neutral active species of halogen type atoms and molecules, is disposed within the vacuum container.

According to this configuration, the neutral active species which have diffused in the vacuum container and do not contribute to the etching, are absorbed by the reactive member disposed in the vacuum container, and after reacting with the reactive member, reactants are desorbed from the member. This reactive member is disposed, for example, on an inner wall of the vacuum container. Therefore, the corrosion on each of the sections in the vacuum container is effectively prevented.

Moreover, where this reactive member is disposed at a holder for holding a material to be etched in the vacuum container, or where this holder itself is formed of the above reactive member, the neutral active species attempting to go around to the back surface of the material to be etched on the holder are absorbed by this reactive member so that after they react with the reactive member, reactants desorb from the member. Therefore, over etching on a periphery section of the material to be etched is prevented.

Also where an exhaust port which performs vacuum exhaustion inside the vacuum container is formed by the reactive member which reacts with the neutral active species of halogen type atoms and molecules, the neutral active species diffused within the vacuum container are absorbed by this reactive member and the reactants desorb from the reactive member. Therefore, corrosion on each of the sections in the vacuum container is further effectively prevented.

### BRIEF DESCRIPTION OF THE DRAWINGS

Fig. 1 is a diagram showing a diagrammatic configuration of a plasma etching apparatus according to one embodiment of the present invention.

Figs. 2A and B are diagrams showing shapes of a reactive member disposed at a substrate holder which is a component of the plasma etching apparatus shown in Fig. 1.

Figs. 3A-C are diagrams showing the comparison between semiconductor wafer surfaces respectively obtained from a plasma etching apparatus according to the present embodiment and a related art plasma etching apparatus for the flatness of the wafer surfaces.

### DESCRIPTION OF THE PREFERRED EMBODIMENT

The following explains one embodiment of a plasma etching apparatus according to the present invention.

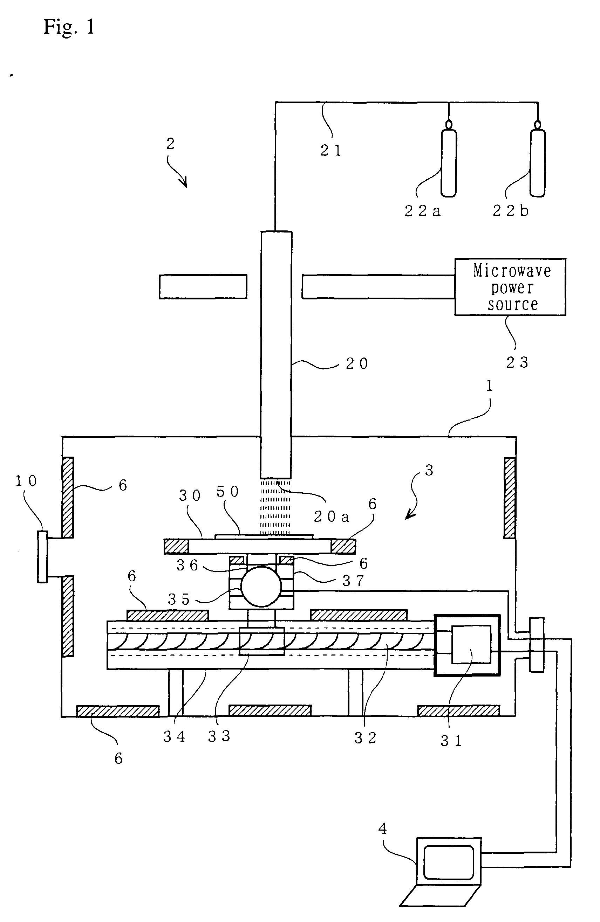

Fig. 1 is a diagram showing diagrammatic configuration of the plasma etching apparatus according to the present invention.

This plasma etching apparatus comprises a plasma generation section 2 attached to a top section of a vacuum container 1 which is a processing chamber, an X-Y stage 3 provided within the vacuum container 1, and an X-Y stage control section 4. The inside of the vacuum container 1 is exhausted via a vacuum exhaust port 10.

The plasma generation section 2 comprises a reaction tube 20, cylinders 22a, 22b containing gases to be supplied to the reaction tube 20 via a supply tube 21, and a microwave power source 23 externally attached to the reaction tube 20. The reaction tube 20 is affixed at the top section of the vacuum container 1, and its ejection outlet 20a is oriented to the side of the X-Y stage 3. In the cylinders 22a, 22b, gases such as SF₆ (sulfur hexafluoride) and O₂ (oxygen) are contained. The microwave power source 23 is formed by a magnetron etc., and is able to irradiate microwaves toward a plasma region within the reaction tube 20 at a specific power.

When each of the gases at a specific composition ratio is supplied into the reaction tube 20 to be mixed, and microwaves at a specific power are irradiated by the microwave power source 23 to a plasma generation region in the reaction tube 20, plasma is generated. The gas turned into a plasma is blasted from the ejection outlet 20a of the reaction tube 20 locally onto the surface of a semiconductor wafer 50 which is vacumm-held on a substrate holder 30, so that the surface of the semiconductor wafer 50 is locally etched by neutral active species of mainly fluorine. At this point, the distance between the ejection outlet 20a and the surface of the semiconductor wafer 50 is set short to an extent allowing the local etching.

The X-Y stage 3 moves the substrate holder 30 in an X direction (in Fig. 1, a perpendicular direction in relation to the paper surface) and in a Y direction (left and right direction in Fig. 1). A servo-motor 31, a ball screw 32 and a bearing 33 constitute a Y-direction driving mechanism which moves the substrate holder 30 in the Y direction, and the ball screw 32 and the bearing 33 are housed by a cover 34. Also, a servo-motor 35, a ball screw connected to this servo-motor 35 and a bearing 36 constitute an X-direction driving mechanism. The ball screw connected to the servo-motor 35 is not shown in the figure since it is behind the servo-motor 35, and this ball screw and the bearing 36 are housed by a cover 37.

The bearing 33 constituting the Y-direction driving mechanism is affixed to the X-direction driving mechanism, and when the bearing 33 is moved as the ball screw 32 rotates, the X-direction driving mechanism is moved along with the movement of the bearing 33. Also, the bearing 36 constituting the X-direction driving mechanism is affixed to the substrate holder 30, and when the bearing 36 is moved as the ball screw behind the servo-motor 35 rotates, the substrate holder 30 moves along with the movement of the bearing 36.

That is, by the Y-direction driving mechanism, the X-direction driving mechanism and the substrate holder 30 are moved in Y-direction, and by X-direction driving mechanism, the substrate holder 30 is moved in the X direction, so that the substrate holder 30 is moved in an X-Y direction. This movement is controlled by controlling the rotation of each of the servo-motors 31, 35 by the X-Y stage control section 4.

In the plasma etching apparatus according to the present embodiment, reactive members 6 made of a silicon carbide (SiC) which reacts with neutral active species of fluorine are disposed within the vacuum container 1. These reactive members 6 are in a shape of a block, and are disposed at the substrate holder 30 vacuum-holding the semiconductor wafer 50 which is the material to be etched, on covers 34, 37 near the substrate holder 30, and on the inner walls of the vacumm container 1. The vacuum container 1 and the covers 34, 37 are made of stainless steel.

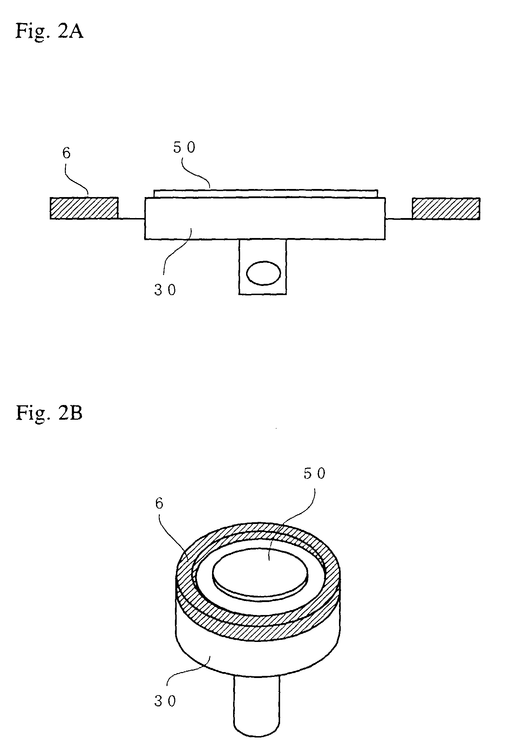

The reactive member 6 to be disposed at the substrate holder 30 may be in a shape of a ring surrounding the outer periphery of the substrate holder 30 as shown in Fig. 2A, or the ring-shaped reactive member 6 may be mounted on top of the periphery of the substrate holder 30 as shown in Fig. 2B, so that it surrounds the perimeter of the semiconductor wafer 50. Also, the substrate holder 30 itself may be formed by a reactive member made of SiC.

With the plasma etching apparatus provided with such reactive members 6 according to the present embodiment, the neutral active species of fluorine that are ejected from the reaction tube 20 toward the semiconductor wafer 50, and diffused within the vacuum container 1, and which do not contribute to the etching, are first absorbed by the reactive member 6 made of SiC disposed at the substrate holder 30. In a case where the substrate holder 30 itself is made of the reactive member of SiC, they are absorbed by the substrate holder 30 itself. These neutral active species of fluorine absorbed by the reactive member 6 or the substrate holder 30 itself, react with the reactive member 6, are turned into SiF₄, and desorb from the reactive member 6.

Therefore, in the plasma etching apparatus according to the present embodiment, those neutral active species of fluorine that do not contribute to the etching can be absorbed by the reactive member 6 disposed at the substrate holder 30", or by the substrate holder 30 itself, before the neutral active species of fluorine reach the inner wall surface of the vacuum container 1. Thus, corrosion on the inner wall of the vacuum container 1 can be reduced.

In addition, the neutral active species of fluorine that attempt to go around to the back surface of the semiconductor wafer 50 on the substrate holder 30 are absorbed by the reactive member 6 disposed on the substrate holder 30 or the substrate holder 30 itself, react with the reactive member 6, are turned into SiF₄ and desorb. Therefore, the edge sections of the periphery of the semiconductor wafer 50 would not be etched by the neutral active species of fluorine attempting to go around to the back surface of the semiconductor wafer 50 as they would be in the conventional way.

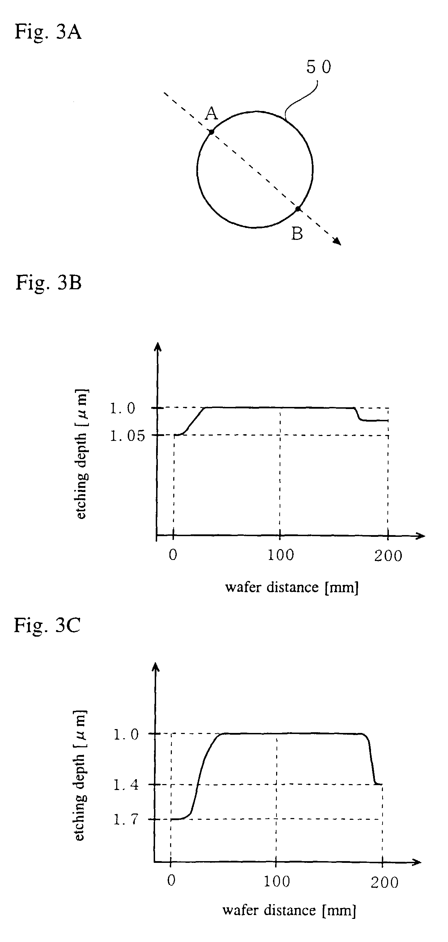

Figs. 3A-C are diagrams showing an experiment result of the comparison for flatness of the semiconductor wafers 50 obtained respectively by performing plasma etching on the surfaces of the semiconductor wafers 50 by the plasma etching apparatus according to the present embodiment and a related art plasma etching apparatus which does not include the reactive members 6.

The plasma etching in this experiment was performed by moving the reaction tube 20 in relation to the semiconductor wafer 50 along a direction indicated by the broken line in Fig. 3A. This plasma etching was performed for 200 hours under a condition of; gas type:SF₆, gas flow rate: 150SCCM, gas pressure: 1.5Torr, and microwave power source: 350W.

Fig. 3B is a profile indicating the flatness of the surface of the semiconductor wafer 50 etched by the plasma etching apparatus according to the present embodiment in which a reactive member 6 is disposed at the substrate holder 30, and Fig. 3C is a profile indicating the flatness of the surface of the semiconductor wafer 50 etched by the related art plasma etching apparatus having the system configuration shown in Fig. 1 in which the reactive member 6 is not disposed at the substrate holder 30.

The Horizontal axis of each of the graphs showing these profiles is wafer distance (mm), and a distance "0" represents an edge section A on one end of the semiconductor wafer 50 (refer Fig. 3A), and a distance "200(mm)" represents an edge section B on the other end of the semiconductor wafer 50 (refer Fig. 3A). Also, the Vertical axis of each of these graphs represents etching depth (µm) from the surface of the semiconductor wafer 50.

From the profile shown in Fig. 3B, it can be seen that each of the edge sections A, B of the semiconductor wafer 50 etched by the plasma etching apparatus according to the present embodiment are etched at shallow depths of less than 0.05 µm. On the other hand, from the profile shown in Fig. 3C, it can be seen that for the semiconductor wafer 50 etched by the related art plasma etching apparatus, the edge sections are etched by 0.7µm in the proximity of the edge section A on one end, and 0.4µm in the proximity of the edge section B on the other end, which are deeper compared to the center section of the wafer.

From the results of this experiment, the effectiveness of the reactive member 6 disposed at the substrate holder 30 was demonstrated. That is, the neutral active species of fluorine that attempt to go around to the back surface of the semiconductor wafer 50 are promptly absorbed by the reactive member 6 disposed adjacent to the perimeter of the semiconductor wafer or the substrate holder 30 itself, so that over etching on the edge sections of the semiconductor wafer 50 is restrained. As a result, with the plasma etching apparatus according to the present embodiment, the surface of the semiconductor wafer 50 is etched evenly across the entire surface.

Moreover, in the plasma etching apparatus according to the present embodiment, reactive members 6 are also disposed on the inner wall of the vacuum container 1 and on the covers 34, 37. Therefore, the neutral active species of fluorine that have not been absorbed by the reactive member 6 disposed at the substrate holder 30 and have diffused within the vacuum container 1 are absorbed also by these reactive members 6. The neutral active species of fluorine absorbed by these reactive members 6 also react with the reactive members 6 as above described, turn into SiF₄, and desorb from the reactive members 6. The desorbed SiF₄ is exhausted to the outside via the vacuum exhaust port 10. Hence, with the plasma etching apparatus according to the present embodiment, the corrosion by the neutral active species of fluorine that do not contribute to the etching would not occur on the inner wall of the vacuum container 1 and the covers 34, 37 etc. as it would in the conventional way.

In the embodiment described above, the vacuum exhaust port 10 for vacuum-exhausting the vacuum container 1, was explained as being made of stainless steel, the same material as the vacuum container 1, however, this vacuum exhaust port 10 itself may be formed of the reactive member which reacts with the neutral active species of fluorine. Since the gas within the vacuum container 1 concentrates to the vacuum exhaust port 10, by forming the vacuum exhaust port 10 from the reactive member, the neutral active species of fluorine diffused within the vacuum container 1 are effectively absorbed by the vacuum exhaust port 10 and eliminated.

Furthermore, although the reactive member 6 was explained as being SiC in the above embodiment, the material of this reactive member 6 may be any material which reacts with the neutral active species of halogen type atoms and molecules, and it may be, for example, solely Si, or an Si compound such as SiN which is a nitride of Si. Moreover, although the halogen is explained as being fluorine in the above embodiment, this halogen may also be chlorine or a mixture of fluorine and chlorine.

In each of the cases where the component of the present embodiment is altered as the above, an effect similar to the above explained embodiment can be obtained respectively.

## Claims

1. A plasma etching apparatus for performing plasma etching within a vacuum container (1) using a halogen type gas; CHARACTERIZED IN THAT a member (6) which reacts with neutral active species of halogen type atoms and molecules is disposed within said vacuum container (1).

2. A plasma etching apparatus according to claim 1; wherein said reactive member (6) is disposed at a holder (30) for holding a material (50) to be etched in said vacuum container (1).

3. A plasma etching apparatus according to claim 1; wherein said reactive member (6) is disposed on an inner wall of said vacuum container (1).

4. A plasma etching apparatus for performing plasma etching within a vacuum container (1) using a halogen type gas; CHARACTERIZED IN THAT a holder (30), which holds a material (50) to be etched in said vacuum container (1), is formed of a member which reacts with neutral active species of halogen type atoms and molecules.

5. A plasma etching apparatus for performing plasma etching within a vacuum container (1) using a halogen type gas; CHARACTERIZED IN THAT a vacuum exhaust port (10), which vacuum-exhausts the inside of said vacuum container (1), is formed of a member which reacts with neutral active species of halogen type atoms and molecules.

6. A plasma etching apparatus according to any preceding claim; wherein said reactive member (6) is made of silicon or a silicon compound.

7. A plasma etching apparatus according to any of claims 1 to 6; wherein said halogen type gas is fluorine.

8. A plasma etching apparatus according to any of claims 1 to 6; wherein said halogen type gas is chlorine.

9. A plasma etching apparatus according to any one of claims 1 to 6; wherein said halogen type gas is a mixture of fluorine and chlorine.
